# EUROPÄISCHE PATENTSCHRIFT

(11) **EP 0 310 764 B1**
(45) Veröffentlichungstag und Bekanntmachung des Hinweises auf die Patenterteilung: **04.01.1995**
(21) Anmeldenummer: 88111810.3
(22) Anmeldetag: 22.07.1988
(51) Int. Cl.: G01D 5/244, G01D 5/245, H03M 1/22

(54) **Auswerteschaltung für Rechtecksignale**
Evaluation circuit for pulse signals
Circuit d'évaluation pour impulsions

(30) Priorität: 30.09.1987 DE 3732962
(43) Veröffentlichungstag der Anmeldung: 12.04.1989
(73) Patentinhaber: Dr. Johannes Heidenhain GmbH, D-83292 Traunreut (DE)
(72) Erfinder: Kranitzky, Walter, Dr., D-8220 Traunstein (DE)

(56) Entgegenhaltungen:
- DE-A- 2 726 346
- DE-A- 3 523 551
- GB-A- 2 100 487

## Beschreibung

Die Erfindung bezieht sich auf eine Auswerteschaltungsanordnung für Rechtecksignale gemäß dem Oberbegriff des Anspruches 1.

Bei inkrementalen Längen- oder Winkelmeßeinrichtungen gehört es zum Stand der Technik, daß mit Hilfe einer entsprechenden Abtastbaueinheit durch Abtasten einer gitterartigen inkrementalen Meßteilung periodische Analogsignale erzeugt werden. Zur Erkennung der Bewegungsrichtung und zur Vermeidung von Symmetriefehlern der Signale erfolgt die Abtastung mit vier Abtastfeldern, die in Meßrichtung um ein Viertel der Gitterteilungsperiode zueinander versetzt sind.

Da für die meisten Anwendungsfälle die Auflösung entsprechend der Gitterteilungsperiode der Meßteilung nicht ausreichend ist, hat es bereits eine Vielzahl von Vorschlägen gegeben, die Abtastsignale zu unterteilen.

So ist beispielsweise aus der CH-PS 407 569 eine Unterteilungsschaltung bekannt, bei der mit Hilfe einer Vielzahl von Triggern die Abtastsignale unterteilt und auf diese Weise vervielfacht werden. Die in dieser Druckschrift beschriebene Schaltung bietet jedoch keine Gewähr dafür, daß bei entsprechend feiner Unterteilung die getriggerten Signale hinsichtlich ihrer Reihenfolge und ihres Flankenabstandes exakt synchronisiert sind. In Abhängigkeit vom Grad der Unterteilung, von der Meßgeschwindigkeit, von Störeinflüssen elektrischer und mechanischer Art (Störimpulse, Erschütterungen) und dergleichen kann es bei der inkrementalen Auswertung der getriggerten Rechtecksignale zu Fehlzählungen kommen.

Es können zu geringe Flankenabstände, Überschneidungen oder unzulässige Signalzustände bzw. Signalfolgen der Triggersignale auftreten.

Während des Meßbetriebes sind Fehlzählungen nicht erkennbar, da die letzten Stellen der Anzeige in der Auswertebaueinheit wegen des schnellen Wechsels ihres Anzeigewertes nicht ablesbar sind. Kommt die Meßeinrichtung jedoch zum Stillstand, und ist dann das Meßergebnis ablesbar, so muß gewährleistet sein, daß alle Inkremente bzw. alle daraus durch Unterteilung gewonnenen Rechtecksignale wirklich gezählt worden sind. Die Summe, oder in negativer Meßrichtung die Differenz aller überfahrenen Inkremente muß exakt dem Anzeigewert entsprechen, da sie das Maß für den zurückgelegten Weg darstellen.

Wenn beispielsweise Rechtecksignale, die durch Unterteilung aus den abgetasteten Signalen gewonnen wurden, einen so geringen Flankenabstand haben, daß eine sichere Zählung nicht möglich ist, so werden nicht alle Rechtecksignale gezählt, und in der Auswerteeinrichtung wird ein geringeres Meßergebnis angezeigt, als von der Meßeinrichtung tatsächlich abgefahren worden ist.

Zu ähnlichen, falschen Meßergebnissen führen die weiteren, oben aufgeführten fehlerhaften Signalzustände.

Aus dem JP-Patent Abstract 59-105721 ist zwar eine Schaltung zur Synchronisation von Rechtecksignalen mit Hilfe eines Schaltwerks bekannt, bei dem bistabile Kippstufen vorgesehen sind, dort erfolgt jedoch die Synchronisation durch Aussuchen des Nächstliegenden von mehreren Impulsen.

Aus der US-A-4,096,396 ist ferner ein Takterzeugungssystem bekannt, bei dem die Freigabe einer Änderung des Signalzustandes von Netzwerken CT1, CT2 und CT3 von den Signalzuständen an den Ausgängen der benachbarten Netzwerke abhängig ist.

Aus der DE-C-35 23 551 ist weiterhin ein Verfahren bekannt, Rechtecksignale mit Hilfe einer Schaltung zu synchronisieren, bei dem die Abfolge der Rechtecksignale durch ein periodisches Hilfssignal getaktet wird, und Änderungen des Signalzustandes einer Kippstufe von den Signalzuständen der benachbarten Kippstufen abhängig sind.

Auch mit Hilfe dieses Verfahrens können Fehler, die beispielsweise dadurch auftreten, daß sich zwei Signal-Zählflanken überholen, nicht korrigiert, sondern nur erkannt werden.

In der DE-A- 27 26 346 ist ein Kontrollsystem mit einem Taktgenerator, einem Komparator für elektrische Signale und einem Zähler beschrieben. Dieses Kontrollsystem erzeugt ein Ausgangskontrollsignal, wenn ein erstes und ein zweites Signal gleich sind.

Der Erfindung liegt die Aufgabe zugrunde, eine Auswerteschaltung für Rechtecksignale anzugeben, die noch fehlersicherer ist, als die Verfahren und Schaltungen nach dem Stand der Technik.

Diese Aufgabe wird durch eine Auswerteschaltungsanordnung mit den Merkmalen des Anspruches 1 gelöst und durch Schaltungen gemäß den abhängigen Ansprüchen wird die Erfindung in besonders vorteilhafter Weise ausgestaltet.

Die erfindungsgemäße Schaltung hat folgende Vorteile:
- Die Schaltung nimmt nach dem Einschalten selbsttätig einen eindeutig definierten Zustand ein, sofern ein gültiger Code vorliegt. Ein Resetimpuls wird nicht benötigt.
- Abweichungen des Eingangscodes vom Ausgangscode bis zu einer halben Maßstabsperiode werden ausgeglichen.
- Störungen des Eingangssignals haben keine Wirkung auf den Ausgang.
- Die Schaltung ist für beliebige Unterteilungsfaktoren verwendbar, wobei der Aufwand mit steigender Unterteilung bei weitem nicht linear anwächst.
- Die Schaltung ist leicht kaskadierbar.

Mit Hilfe der Zeichnungen soll anhand eines Ausführungsbeispieles die Erfindung näher erläutert werden.

Es zeigt:
- Figur 1: ein Blockschaltbild;
- Figur 2: ein Signaldiagramm und
- Figur 3: ein Blockschaltbild einer bevorzugten Ausführungsform.

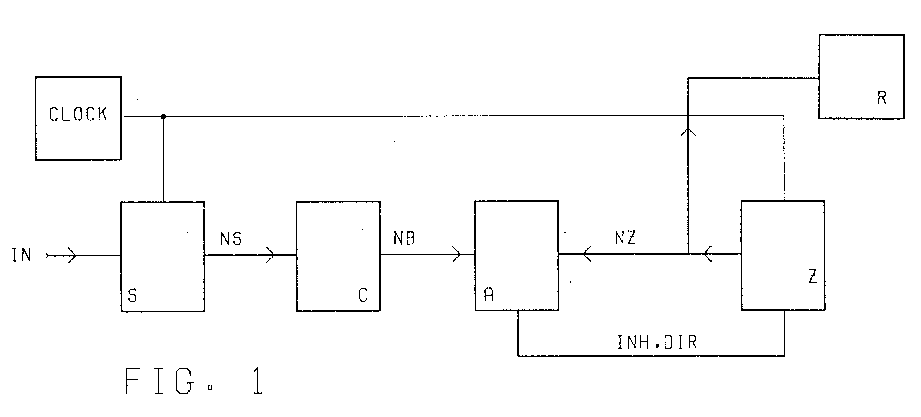

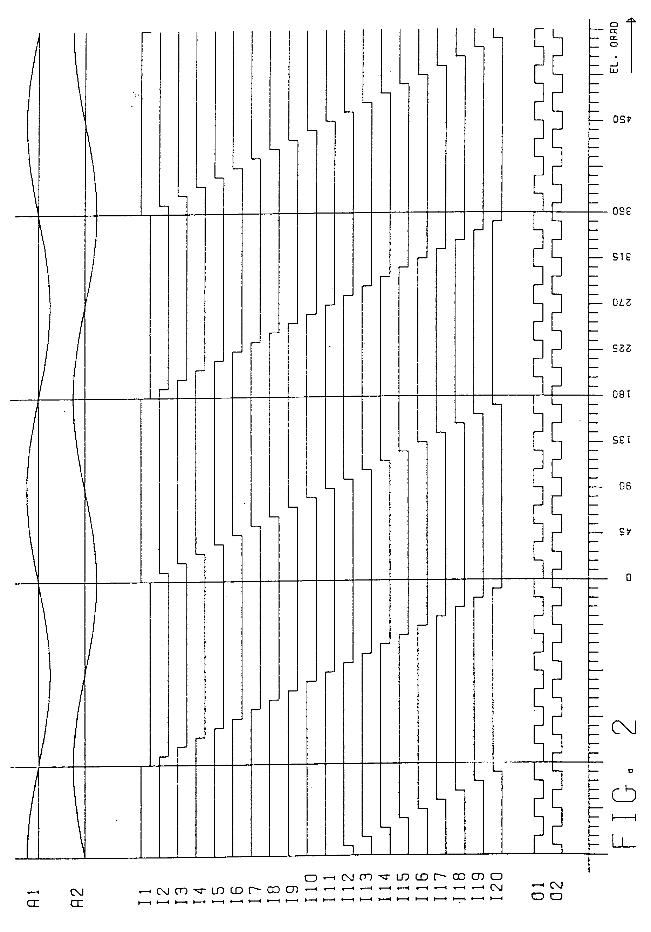

Das in Figur 1 gezeigte Blockschaltbild ist einer nicht dargestellten Unterteilungselektronik für ein inkrementales Positionsmeßsystem nachgeschaltet, auf die bereits in der Beschreibungseinleitung Bezug genommen wurde. Einem Speicher S werden Rechtecksignale I1 bis I20 zugeführt, deren Abfolge in Figur 2 dargestellt ist und die mittels einer bekannten Unterteilungselektronik aus zwei um 90° zueinander phasenverschobenen analogen Abtastsignalen A1 und A2 einer inkrementalen Meßeinrichtung gewonnen wurden.

Der Unterteilungsfaktor 10 wird beispielsweise derart festgelegt, daß eine Maßstabsperiode in 40 Meßschritte aufgeteilt ist. Durch Kombination der beiden sinusförmigen, um 90° phasenverschobenen Abtastsignale A1, A2 in Widerstandsnetzwerken werden Sinussignale mit geeigneten Phasenwinkeln gebildet. Nachgeschaltete Komparatoren liefern die gezeigten Rechecksignale I1...I20, deren Schaltflanken dem Nulldurchgang der einzelnen Sinussignale entsprechen und jeweils um 9° phasenverschoben sind.

Die Figur 2 zeigt die Ein- und Ausgangssignale I1...I20 einer Unterteilungselektronik mit dem Unterteilungsfaktor 10 bei störungsfreiem Betrieb, ideal sinusförmigen Eingangsströmen und Vernachlässigung von Bauteiltoleranzen und Laufzeiteffekten. Sie arbeitet mit 20 Komparatoren und führt zu 40 Zählflanken. In herkömmlichen Unterteilungsschaltungen werden aus den Komparatorsignalen zwei um 90° phasenverschobene Rechtecksignale gebildet (01,02). Diese werden über einen Richtungsdiskriminator einem Zähler zugeführt, der nicht dargestellt ist.

In der Praxis sind die erwähnten idealen Bedingungen in der Regel nicht gewährleistet. Abweichungen der Eingangssignale A1, A2 von der Sinusform, Offset der Eingangssignale, Toleranzen der Widerstände und Komparatoren sowie unterschiedliche Laufzeit der einzelnen Sinussignale führen dazu, daß die Flanken der Ausgangssignale I1...I20 bei schnellen Maßstabsbewegungen zeitlich sehr nahe zusammenrücken und die Maximalfrequenz des Zählers überschritten wird. Störimpulse können ein sporadisches Umkippen einzelner Komparatoren bewirken. Es kommt zu Abweichungen der Ausgangssignale I1...I20 von den 40 gültigen Kombinationen und damit ebenfalls zu Fehlzählungen.

Verwendet man an Stelle der herkömmlichen, kontinuierlich arbeitenden Komparatoren getaktete Komparatoren (notwendig für die Integration in CMOS Technologie), so kommt es bei Annäherung an die maximale Verfahrgeschwindigkeit des Maßstabes sehr häufig zu Codesprüngen der Ausgangssignale I1...I20.

Die zwanzig Rechtecksignale I1...I20 aus Figur 2 werden nun gemäß der Schaltung in Figur 1 zunächst in einem Speicher S zwischengespeichert. Dazu enthält der Speicher S zwanzig Flip-Flops - hier nicht dargestellt - deren Takteingänge gemeinsam von einem Hilfssignal CLK angesteuert werden, das von einem Taktgenerator CLOCK geliefert wird.

Aufgrund der Funktionsweise der vorgeschalteten Unterteilungselektronik können die Flip-Flops innerhalb einer Maßstabsperiode 40 gültige Zustände einnehmen, alle restlichen möglichen Zustände sind als ungültige Zustände definiert.

Die Ausgänge der Flip-Flops sind mit einem Codewandler C verbunden, der einen Binär-Code NB erzeugt, welcher von den jeweiligen Zuständen der Ausgangs-Signalkombinationen NS an den Ausgängen der Flip-Flops abhängig ist.

Ein Vorwärts-/Rückwärtszähler Z, der als Binärzähler ausgebildet ist, liefert ebenfalls einen Binär-Code NZ, der seinen Zählerstand darstellt. Der Zählerstand wird durch Aufsummieren von Taktimpulsen gebildet, die durch das bereits eingangs erwähnte Hilfssignal CLK dem Zähler Z zugeführt werden. Ob der Zählerstand von den mit fester Taktfrequenz zugeführten Taktimpulsen des Hilfssignales CLK verändert wird, hängt von Steuersignalen ab, auf die später noch Bezug genommen wird.

Sowohl der vom Codewandler C gelieferte Binär-Code NB als auch der den Zählerstand des Vorwärts-/Rückwärtszählers Z darstellende Binär-Code NZ werden einem Vergleichsglied A zugeführt, in dem die beiden Codes NB und NZ verglichen werden. Das Vergleichsglied A ist über wenigstens eine Steuerleitung INH, DIR mit dem Vorwärts-/Rückwärtszähler Z verbunden.

Abhängig vom Ergebnis des Vergleiches der beiden Binär-Codes NB und NZ im Vergleichsglied A wird durch noch näher zu beschreibende Signale - die über die Steuerleitung INH, DIR dem Vorwärts-/Rückwärtszähler Z zugeführt werden - der Zählerstand vorzeichenrichtig verändert oder nicht verändert.

Der Zählerstand NZ kann sowohl parallel ausgewertet als auch in eine Dekodierschaltung OS eingespeist werden. Die Dekodierschaltung OS wandelt den Binär-Code NZ in einen 2-Bit Gray-Code um, aus dem die Ausgangssignale 01, 02 für eine Auswerteschaltung R gebildet werden.

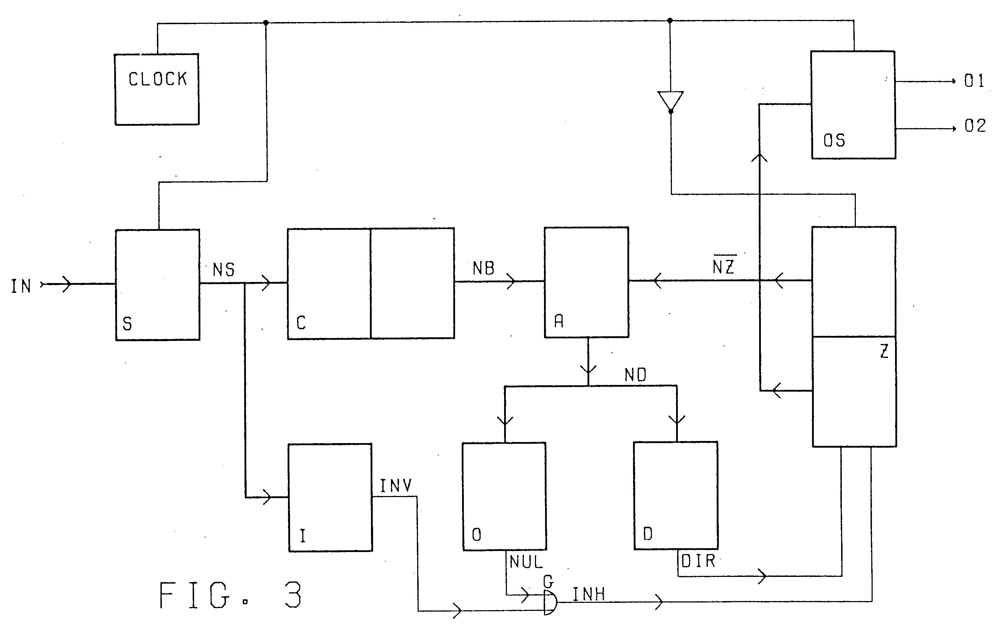

In Figur 3 ist ein Blockschaltbild einer besonders vorteilhaften und deshalb bevorzugten Ausführungsform der erfindungsgemäßen Auswerteschaltung dargestellt.

Dem bereits erläuterten Speicher S ist neben dem Codewandler C auch noch ein Logikbaustein I nachgeschaltet, in dem die Ausgangs-Signalkombinationen NS auf gültige und ungültige Zustände überprüft werden. Liegt einer der ungültigen Zustände vor, so wird von dem Logikbaustein I ein Sperrsignal INV über die Steuerleitung INH in den Vorwärts-/Rückwärtszähler Z eingespeist, so daß dessen Zählerstand durch das Hilfssignal CLK nicht verändert werden kann.

Der Codewandler C ist als zweistufiger Wandler ausgelegt, durch den die Ausgangs-Signalkombinationen NS, die an den Ausgängen des Speichers S anliegen, zunächst in einen Gray-Code und anschließend in einen Binär-Code NB umgewandelt werden. Diese Art der Zuordnung ermöglicht zusammen mit der Zwischenschaltung eines Gray-Code-Wandlers einen besonders einfachen Aufbau der Schaltung.

Das Vergleichsglied A ist für den Vergleich der beiden Binär-Codes NB (vom Codewandler C) und NZ (Zählerstand des Vorwärts-/Rückwärtszählers Z) als Binäraddierer ausgeführt, so daß die Differenz der beiden Binär-Codes als Summe ND aus dem Binär-Code NB und dem invertierten Binär-Code N̅Z̅ des Zählerstandes ermittelt wird.

Im Ausgangskreis des Vergleichsgliedes A liegen noch ein Nullselektor 0 und ein Richtungsselektor D, die mit dem Vorwärts-/Rückwärtszähler Z verbunden sind.

Wenn die Überprüfung der beiden Binär-Codes NB und NZ ergibt, daß keine Differenz besteht, so gibt der Nullselektor 0 ein Sperrsignal (NUL) ab, das eine Veränderung des Zählerstandes ebenso verhindert, wie das Sperrsignal INV, das gegebenenfalls vom Logikbaustein I geliefert wird.

Das Sperrsignal NUL wird ebenso wie das Sperrsignal INV an ein Oder-Gatter G geführt, dessen Ausgang über die Steuerleitung INH mit dem Vorwärts-/Rückwärtszähler Z verbunden ist.

Wenn die Überprüfung der beiden Binär-Codes NB und NZ eine Differenz ergibt, so wird über die Steuerleitung DIR vom Richtungsselektor D ein Steuersignal in den Vorwärts-/Rückwärtszähler Z eingespeist, durch das die Zählrichtung zur Veränderung des Zählerstandes in Abhängigkeit von dem Vorzeichen der Differenz bestimmt wird.

Dabei wird die Zählrichtung so gewählt, daß der Zählerstand NZ immer in Richtung der geringsten Differenz nachgeführt wird.

## Patentansprüche

1. Auswerteschaltungsanordnung für Rechtecksignale, die als Eingangs-Signalkombination parallel an einem Speicher mit getakteten bistabilen Kippstufen anliegen, welche von einem periodischen Hilfssignal angesteuert werden, dadurch gekennzeichnet, daß das Hilfssignal (CLK) mit fester Taktfrequenz auch einen Vorwärts-/Rückwärtszähler (Z) ansteuert, dessen Zählerstand (NZ) in Form eines Codes, vorzugsweise in Form eines Binär-Codes, in einem Vergleichsbaustein (A) mit den in einen Code, vorzugsweise Binär-Code (NB), umgewandelten Rechtecksignalen (I1...I20) verglichen wird, und daß in Abhängigkeit vom Vergleich der beiden Codes (NZ und NB) durch das Vergleichsglied (A) über wenigstens eine Steuerleitung (INH, DIR) der Zählerstand des Vorwärts-/Rückwärtszählers (Z) vorzeichenrichtig geändert oder nicht geändert wird.

2. Auswerteschaltung nach Anspruch 1, dadurch gekennzeichnet, daß an den Ausgängen des Speichers (S) ein Codewandler (C) und ein Logikbaustein (I) anliegen, wobei im Codewandler (C) jeweils eine Ausgangs-Signalkombination (NS) in einen Binär-Code (NB) umgewandelt und dem Vergleichsglied (A) zugeführt wird, während im Logikbaustein (I) die Ausgangs-Signalkombination (NS) auf gültige und ungültige Zustände überprüft wird, wobei durch die Logik (I) im Falle ungültiger Zustände ein Sperrsignal (INV) über die Steuerleitung (INH) an dem binären Vorwärts-/Rückwärtszähler (Z) anliegt und der Zählerstand des Vorwärts-/Rückwärtszählers (Z) nicht geändert wird.

3. Auswerteschaltung nach Anspruch 1, dadurch gekennzeichnet, daß zwischen dem Vergleichsglied (A) und dem Vorwärts-/Rückwärtszähler (Z) in der Steuerleitung (INH) ein Nullselektor (0) liegt, durch den dem Vorwärts-/Rückwärtszähler (Z) ein Sperrsignal (NUL) zugeführt wird, wenn die beiden Codes (NB und NZ) gleich sind, so daß der Zählerstand nicht geändert wird.

4. Auswerteschaltung nach Anspruch 2 und 3, dadurch gekennzeichnet, daß die Sperrsignale (INV und NUL) an einem Oder-Gatter (G) liegen, dessen Ausgang über die Steuerleitung (INH) am Vorwärts-/Rückwärtszähler (Z) anliegt.

5. Auswerteschaltung nach Anspruch 2, dadurch gekennzeichnet, daß der Codewandler (C) zweistufig derart ausgebildet ist, daß zunächst die Ausgangs-Signalkombinationen (NS) in einen Gray-Code und dieser dann in einen Binär-Code (NB) gewandelt wird.

6. Auswerteschaltung nach Anspruch 2, dadurch gekennzeichnet, daß das Vergleichsglied (A) als Binäraddierer ausgeführt ist, dem der Binär-Code (NB) vom Codewandler (C) und der invertierte Binär-Code (N̅Z̅) vom Vorwärts-/Rückwärtszähler (Z) zugeführt werden, und der daraus die Differenz bildet.

7. Auswerteschaltung nach Anspruch 1, dadurch gekennzeichnet, daß zwischen dem Vergleichsglied (A) und dem Vorwärts-/Rückwärtszähler (Z) in der Steuerleitung (DIR) ein Richtungsselektor (D) liegt, durch den der Zählerstand in Abhängigkeit vom Codevergleich im Vergleichsglied (A) vorzeichenrichtig geändert wird.

## Claims

1. Evaluation circuit arrangement for pulse signals lying parallel in the form of an input signal combination on a storage device with timed bistable trigger circuits, which are actuated by a periodic auxiliary signal, characterised in that the auxiliary signal (CLK) also actuates at fixed time frequency a forward/backward counter (Z), the counter reading (NZ) of which is compared in the form of a code, preferably in the form of a binary code, in a comparing module (A) with the pulse signals (I1...I20) converted into a code, preferably a binary code (NB), and that on the basis of the comparison of the two codes (NZ and NB) by the comparing module (A), the counter reading of the forward/backward counter (Z) is either changed to the correct prefix sign or is not changed via at least one control line (INH, DIR).

2. Evaluation circuit according to Claim 1, characterised in that a code converter (C) and a logic unit (I) are arranged at the outputs of the storage device (S), wherein a respective output signal combination (NS) is converted in the code converter (C) into a binary code (NB) and passed to the comparing module (A), whereas in the logic unit (I), the output signal combination (NS) is checked for valid and invalid statuses, wherein in the case of invalid statuses, a blocking signal (INV) is passed through the logic (I) via the control line (INH) to the binary forward/backward counter (Z) and the counter reading of the forward/backward counter (Z) is not changed.

3. Evaluation circuit according to Claim 1, characterised in that between the comparing module (A) and the forward/backward counter (Z), a zero selector (O) is located in the control line (INH), through which a blocking signal (NUL) is passed to the forward/backward counter (Z) if the two codes (NB and NZ) are the same, so that the counter reading is not changed.

4. Evaluation circuit according to Claim 2 or 3, characterised in that the blocking signals (INV and NUL) lie at an OR circuit, the output of which is arranged via the control line (INH) at the forward/backward counter (Z).

5. Evaluation circuit according to Claim 2, characterised in that the code converter (C) is a two-stage converter, that the output signal combinations (NS) are first converted into a Gray code and this is then converted into a binary code (NB).

6. Evaluation circuit according to claim 2, characterised in that the comparing module (A) is constructed in the form of a binary adder, to which the binary code (NB) is passed from the code converter (C) and the inverted binary code (N̅Z̅) is passed from the forward/backward counter (Z) and the binary adder forms the difference therefrom.

7. Evaluation circuit according to Claim 1, characterised in that between the comparing module (A) and the forward/backward counter (Z), a direction selector (D) is located in the control line (DIR), through which the counter reading is changed to the correct prefix sign on the basis of the code comparison in the comparing module (A).

## Revendications

1. Agencement de circuit de traitement pour des signaux rectangulaires qui sont envoyés en parallèle sous forme de combinaison de signaux d'entrée à une mémoire à bascules bistables synchronisées qui sont commandées par un signal auxiliaire périodique, caractérisé par le fait que le signal auxiliaire (CLK) commande avec une fréquence d'horloge fixe un compteur/décompteur (Z) dont la position (NZ) présentée sous la forme d'un code, de préférence sous la forme d'un code binaire est comparée dans un module comparateur (A) aux signaux rectangulaires (I1 ... I20) transformés en un code, de préférence en un code binaire (NB), et par le fait qu'en fonction de la comparaison des deux codes (NZ et NB) opérée par le module comparateur (A), la position du compteur/décompteur (Z) est modifiée ou non en accord avec le signe par l'intermédiaire d'au moins une ligne de commande (INH, DIR).

2. Circuit de traitement selon la revendication 1, caractérisé par le fait qu'un convertisseur de code (C) et un module logique (I) sont connectés aux sorties de la mémoire (S), une combinaison de signaux de sortie (NS) étant transformée chaque fois en un code binaire (NB) dans le convertisseur de code (C) puis transmise au module comparateur (A), tandis que sont contrôlés dans le module logique (I) les états valable et non valable de la combinaison de signaux de sortie (NS), en cas d'états non valables le module logique (I) envoyant un signal de blocage (INV) au compteur/décompteur (Z) binaire par l'intermédiaire de la ligne de commande (INH) et la position du compteur/décompteur (Z) n'étant pas modifiée.

3. Circuit de traitement selon la revendication 1, caractérisé par le fait qu'un sélecteur de zéro (O) est placé dans la ligne dc commande (INH) entre le module comparateur (A) et le compteur/décomptern (Z), sélecteur au moyen duquel un signal de blocage (NUL) est envoyé au compteur/décompteur (Z) lorsque les deux codes (NB et NZ) sont identiques, de telle sorte que la position du compteur n'est pas modifiée.

4. Circuit de traitement selon les revendications 2 et 3, caractérisé par le fait que les signaux de blocage (INV et NUL) sont envoyés à une porte OU (G) dont la sortie est connectée au compteur/décompteur (Z) par l'intermédiaire de la ligne de commande (INH).

5. Circuit de traitement selon la revendication 2, caractérisé par le fait que le convertisseur de code (C) est à deux étages de telle sorte que la combinaison de signaux de sortie (NS) est d'abord transformée en un code de gris, lequel code est ensuite transformé en un code binaire (NB).

6. Circuit de traitement selon la revendication 2, caractérisé par le fait que le module comparateur (A) est agencé sous forme de module additionneur binaire auquel sont envoyés le code binaire (NB) provenant du convertisseur de code (C) et le code binaire inversé (NZ) provenant du compteur/décompteur (Z) et qui, à partir de ceux-ci, forme la différence.

7. Circuit de traitement selon la revendication 1, caractérisé par le fait qu'un sélecteur de direction (D) est placé dans la ligne de commande (DIR) entre le module comparateur (A) et le compteur/décompteur (Z), sélecteur de direction au moyen duquel la position du compteur est modifiée en accord avec le signe en fonction de la comparaison opérée des codes dans le module comparateur (A).
